# EUROPÄISCHE PATENTSCHRIFT

(11) **EP 2 390 914 B1**
(45) Veröffentlichungstag und Bekanntmachung des Hinweises auf die Patenterteilung: **20.11.2013**
(21) Anmeldenummer: 11162176.9
(22) Anmeldetag: 13.04.2011
(51) Int. Cl.: H01L 23/482, H05K 3/32

(54) **Anordnung zweier Verbindungspartner mit einer Niedertemperatur-Drucksinterverbindung und Herstellungsverfahren hierzu**
Assembly of two connection partners with low temperature pressure interconnection and method for producing same
Agencement de deux partenaires de liaison à l'aide d'une interconnexion de pression à basse température et son procédé de fabrication

(30) Priorität: 27.05.2010 DE 102010021765
(43) Veröffentlichungstag der Anmeldung: 30.11.2011
(73) Patentinhaber: SEMIKRON Elektronik GmbH & Co. KG, 90431 Nürnberg (DE)
(72) Erfinder: Sagebaum, Ulrich, 90537 Feucht (DE); Großmann, Jörn, 90419 Nürnberg (DE)

(56) Entgegenhaltungen:
- EP-A2- 0 242 626
- EP-A2- 2 042 260
- DE-A1- 3 414 065
- DE-A1-102005 053 553
- DE-A1-102009 000 587

## Beschreibung

Die Erfindung beschreibt ein Herstellungsverfahren zur Herstellung einer Anordnung zweier Verbindungspartner mittels einer Niedertemperatur-Drucksinterverbindung.

Derartige Anordnungen sind beispielhaft auf dem Gebiet der leistungselektronischen Schaltungen hinlänglich bekannt. Dort werden beispielhaft Leistungshalbleiterbauelemente stoffschlüssig mit Substraten verbunden und in Leistungshalbleitermodulen angeordnet.

Beispielhaft beschreibt die DE 10 2005 058 794 A1 eine Vorrichtung für ein getaktetes Verfahren zur Ausbildung einer derartigen Verbindung wobei die Pressvorrichtung für den getakteten Betrieb einen Pressstempel und einen beheizbaren Presstisch aufweist und wobei ein druckstabiles Transportband direkt oberhalb des Presstischs verlaufend angeordnet ist. Zusätzlich ist zwischen dem Substrat mit den hierauf angeordneten Bauelementen und dem Pressstempel eine Schutzfolie vorgesehen.

Gemäß dem Stand der Technik ist es, beispielhaft offenbart in der DE 34 14 065 C2, hierzu allerdings notwendig dass die Kontaktflächen der Verbindungspartner jeweils eine Edelmetall-, vorzugsweise Silberoberfläche aufweist.

Dies ist dahingehend nachteilig, da eine Vielzahl von Verbindungspartnern aus unedlen Metallen oder anderen nichtmetallischen Werkstoffen bestehen. Hierbei müssen gemäß dem Stand der Technik diese Werkstoffe mit einer Edelmetallschicht versehen werden um eine stoffschlüssigen Verbindung mittels Niedertemperatur-Drucksinterns zugänglich zu sein.

Aus der EP 2 042 260 A2 ist ein Verfahren gemäß dem Oberbegriff von Anspruch 1 zur Herstellung einer elektrisch leittähigen oder wärmeleitfähigen Verbindung zur Kontaktierung zweier Elemente bekannt, wobei aus einer Silberverbindung elementares Silber zwischen übereinander stehenden Kontaktfläche gebildet wird.

Aus der DE 10 2005 053 553 A1 ist ein Lagerstabiles Gel, das als Hauptkomponenten eine Carbonsäurekomponente, eine Aminkomponente und eine Lösungsmittelkomponente enthält, wobei die Carbonsäurekomponente eine thermisch leicht entfernbare Substanz aus einer Carbonsäure oder einem Carbonsäuregemisch ist, die Aminkomponente eine thermisch leicht entfernbare Substanz aus einem tertiären Amin oder eine Mischung tertiärer Amine ist, und die Lösungsmittelkomponente ein polares Lösungsmittel oder eine Mischung polarer Lösungsmittel ist, bekannt.

Aus der EP 0 242 626 A2 ist ein Verfahren zur Befestigung von elektronischen Bauelementen, insbesondere von grossflächigen Leistungshalbleitern, auf einem Substrat durch Drucksintern, bekannt.

Der Erfindung liegt die Aufgabe Herstellungsverfahren zur Herstellung einer Anordnung mit einer stoffschlüssigen Verbindung zweier Verbindungspartner vorzustellen, wobei mindestens einer der beiden Verbindungspartner eine zu verbindende Kontaktfläche aufweist, die aus einem unedlen Metall besteht und wobei die stoffschlüssige Verbindung eine Niedertemperatur-Drucksinterverbindung ist.

Die Aufgabe wird erfindungsgemäß gelöst durch ein Verfahren gemäß Anspruch 1. Bevorzugte Ausführungsformen sind in den jeweiligen abhängigen Ansprüchen beschrieben.

Die Anordnung weist zwei Verbindungspartner auf, die mittels einer Niedertemperatur-Drucksinterverbindung miteinander stoffschlüssig verbunden sind. Hierzu weist jeder der beiden Verbindungspartner jeweils eine Kontaktfläche als Teil eines Oberflächenabschnitts auf. Die jeweiligen Kontaktflächen der beiden Verbindungspartner sind mittels eines edelmetallhaltigen Verbindungsmittels stoffschlüssig miteinander verbunden. Dieses Verbindungsmittel weist einen Masseanteil an Edelmetall auf, der bis 100% beträgt. Vorteilhaft sind hierbei Werte zwischen 80% und 99% Masseprozent.

Hierzu bildet die Kontaktfläche des jeweiligen Verbindungspartners einen Teil eines Oberflächenabschnitts. Bei mindestens einem der beiden Verbindungspartner besteht dieser Oberflächenabschnitt aus einem unedlen Metall, dessen Oberfläche im Bereich der Kontaktfläche angrenzend an das Verbindungsmittel metallisch ist und dessen lateral an diese Kontaktfläche angrenzender Bereich der Oberfläche ein Metalloxid aufweist. Es ist bevorzugt, wenn das unedle Metall Aluminium, Kupfer oder eine Kupferlegierung ist.

Zur Herstellung einer derartigen Anordnung findet ein Verfahren Anwendung, das gekennzeichnet ist durch diese aufeinander folgenden Schritte:
- Bereitstellen eines ersten Verbindungspartners mit einem Oberflächenabschnitt aus einem unedlen Metall mit einer flächigen Metalloxidschicht hierauf.
- Aufbringen eines Reduktionsmittels auf den als erste Kontaktfläche des ersten Verbindungspartners vorgesehenen Bereich des Oberflächenabschnitts. Hierbei wird das Reduktionsmittel vorteilhafterweise in flüssiger oder fester Phase aufgebracht. Das Reduktionsmittel selbst weist hierbei bevorzugt einen Siede- oder Sublimationspunkt auf, der nicht oberhalb und bis zu 20K unterhalb derjenigen Temperatur liegt mit der die Anordnung im weiteren Verlauf der Herstellung zur Ausbildung der Niedertemperatur-Drucksinterverbindung beaufschlagt wird. Grundsätzlich eignet sich hierfür eine Mehrzahl von organischen oder anorganischen Säuren.
- Aufbringen einer Schicht aus einer Sinterpaste auf das Reduktionsmittel. Hierbei ist es bevorzugt, wenn die Kontaktfläche noch vollständig von dem Reduktionsmittel bedeckt ist. Die Sinterpaste zur Ausbildung der Niedertemperatur-Drucksinterverbindung besteht vorzugsweise aus einer Mischung von Edelmetallflocken mit einem Lösungsmittel.
- Anordnen der zweiten Kontaktfläche des zweiten Verbindungspartners auf der Schicht aus Sinterpaste.
- Beaufschlagung der Anordnung mit Temperatur und Druck zur Ausbildung der stoffschlüssigen Niedertemperatur-Drucksinterverbindung. Hierbei findet erst die Temperaturbeaufschlagung statt, wobei nach zumindest teilweiser Erwärmung der Verbindungspartner die Druckbeaufschlagung folgt.

Bei dem erfindungsgemäßen Verfahren wird die Metalloxidschicht durch das Reduktionsmittel zum Metall reduziert, während die Säure selbst oxidiert und bei geeigneter Temperatureinwirkung gleichzeitig siedet oder sublimiert und somit unter der hinzutretenden Druckbeaufschlagung die intermetallische Verbindung zwischen den Edelmetallflocken der Sinterpaste und der Oberfläche des unedlen Metalls ausgebildet wird.

Gleichwirkend zur Herstellung der Anordnung ist es selbstverständlich auch, bei einem zweiten Verbindungspartner aus einem unedlen Metall, wenn das Reduktionsmittel zusätzlich noch auf der Sinterpaste aufgebracht wird. In diesem Fall wird die Metalloxidschicht der Kontaktfläche des zweiten Verbindungspartners zum Metall reduziert.

Der wesentliche Vorteil des erfindungsgemäßen Verfahren ist es, dass Verbindungspartner aus unedlen Metallen nicht in einem kostenintensiven Prozess im Bereich der Kontaktflächen mit einer Edelmetalloberfläche versehen werden müssen. Bei Verbindungspartnern aus nichtmetallischen Werkstoffen ist es ausreichend eine Oberfläche aus einem geeigneten unedlen Metall, beispielhaft Kupfer, vorzusehen, wodurch sich sowohl eine Kostenersparnis als auch ein einfacher Prozessablauf ergeben können.

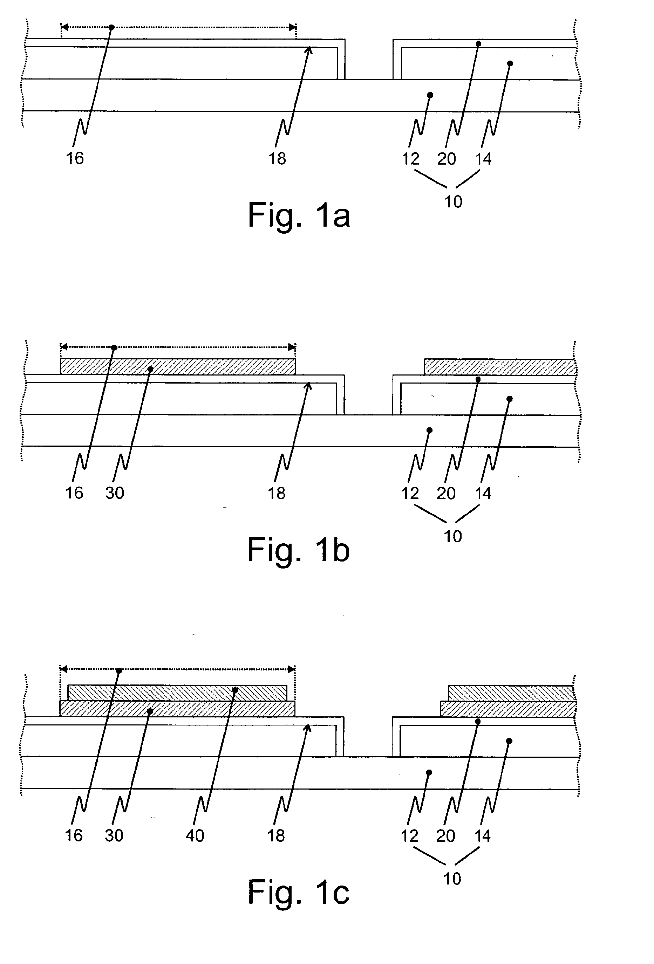

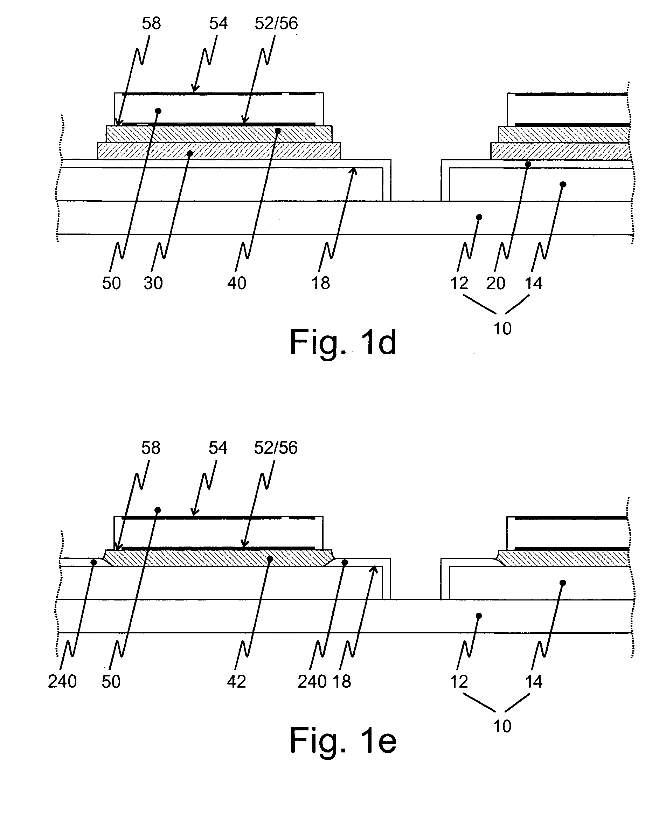

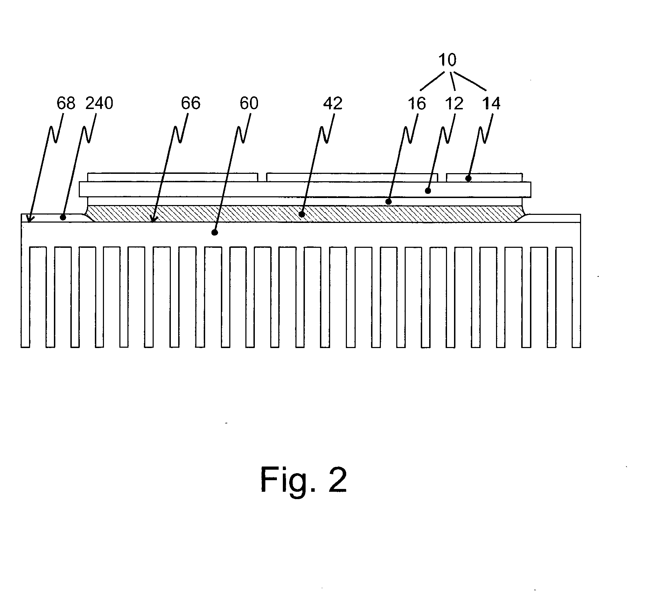

Die erfinderische Lösung wird an Hand der Ausführungsbeispiele der Fig. 1 und 2 weiter erläutert.

Fig. 1 zeigt verschiedene Schritte des erfindungsgemäßen Herstellungsverfahren und in Fig. 1 e eine erste Anordnung.

Fig. 2 zeigt eine zweite Anordnung.

Fig. 1 zeigt verschiedene Schritte des erfindungsgemäßen Herstellungsverfahren und in Fig. 1e eine erste Anordnung, bestehend aus einem Substrat (10) und einem Leistungshalbleiterbauelement (50).

Fig. 1a zeigt einen Ausschnitt eines typischen Substrats (10), wie es im Bereich der Leistungselektronik Anwendung findet. Dieses Substrat (10) besteht aus einem Isolierstoffkörper (12), vorzugsweise eine Industriekeramik wie beispielhaft Aluminiumnitrit und auf mindestens einer der Hauptflächen dieses Isolierstoffkörpers (12) einer Mehrzahl von metallischen Leiterbahnen (14). Diese Leiterbahnen (14) sind vorzugsweise aus einem unedlen Metall, wie beispielhaft aus Kupfer, ausgebildet und gegeneinander elektrisch Isoliert, um Schaltstrukturen auf dem Substrat (10) auszubilden.

Üblicherweise weist die Oberfläche der Leiterbahnen (14) eine Kupferoxidschicht (20) auf, die hauptsächlich durch den Oxidationsprozess des Kupfers mit der Luftsauerstoff entsteht. Derartige oxidbehaftete Oberflächen eines unedlen Metalls sind üblicherweise einer Niedertemperatur-Drucksinterverbindung nicht zugänglich, da hierbei die notwendig Verbindung des Sintermetalls mit dem Verbindungspartner nicht mit der notwendigen Qualität ausgebildet wird. Die jeweiligen dem Isolierstoffkörper (12) abgewandten Seiten der Leiterbahnen (14) bilden die Oberflächenabschnitte (18) des ersten Verbindungspartners, des Substrats (10), die wiederum erste Kontaktabschnitte (16) als Teile dieser Oberflächenabschnitte (18) zur Verbindung mit dem jeweiligen zweiten Verbinddungspartner, hier einem Leistungshalbleiterbauelement (50), darstellen.

Fig. 1 b zeigt das Substrat (10) nach einem ersten Verfahrensschritt, nämlich dem Aufbringen eines Reduktionsmittels (30) auf die erste Kontaktflächen (16) der Oberflächenabschnitte (18) des Substrats (10). Das Reduktionsmittel (30) dient im weiteren Verfahrensablauf der Reduktion des Metalloxids (20) auf der Kontaktfläche (16). Es ist hierbei bevorzugt ein Reduktionsmittel (30) aufzubringen, dessen reduzierende Wirkung nicht unmittelbar einsetzt, worunter verstanden werden soll, dass die reduzierende Wirkung nicht bei Normalbedingungen sondern erst unter einer Temperaturerhöhung, vorzugsweise auf mindestens 100°C in ausreichendem Maße einsetzt.

Derartige Reduktionsmittel (30) können in flüssiger, bevorzugt allerdings in fester Phase auf den ersten Kontaktabschnitt (16) aufgebracht werden. Als sind hierbei anorganische oder eine organische Säure vorgesehen, wobei besonders vorteilhafte Reduktionsmittel gesättigte Fettsäuren, wie Stearinsäure, oder ungesättigte Fettsäuren sind. Bei der Auswahl des Reduktionsmittels kann es ebenso vorteilhaft sein, wenn dieses einen Siede- oder Sublimationspunkt aufweist, der nicht oberhalb und bis zu 20°K unterhalb derjenigen Temperatur liegt mit der die Anordnung im weiteren Verlauf des Verfahrens zur Ausbildung der Niedertemperatur-Drucksinterverbindung beaufschlagt wird.

Im weitern Verfahrensablauf, wird auf gemäß Fig. 1c auf dem Reduktionsmittel (30) die Sinterpaste (40) angeordnet. Hierbei ist es bevorzugt, wenn die Sinterpaste (40) das Reduktionsmittel (30) vollständig oder annährend vollständig überdeckt. Als Sinterpaste (40) findet gemäß dem Stand der Technik eine Mischung aus Edelmetallflocken, vorzugsweise Silberflocken, und einem Lösungsmittel zur Ausbildung der pastösen Eigenschaft Anwendung. Diese Sinterpaste (40) kann auf einem in fester Phase vorliegenden Reduktionsmittel (30) auf bekannte Weise, wie mittels Siebe- oder Schablonendruck oder mittels eines Sprühverfahrens, aufgebracht werden. Auf in flüssiger Phase vorliegenden Reduktionsmitteln (30), können vorgetrocknete Plättchen aus Sinterpaste in einem bekannten Pick-and-Place-Verfahren appliziert werden.

Fig. 1d zeigt ein in einem nächsten Verfahrensschritt auf der Sinterpaste (40) angeordnetes Leistungshalbleiterbauelement (50). Dieses weist eine dem Substrat (10) zugewandte Hauptfläche, die gleichzeitig den zweiten Oberflächenabschnitt (58) des zweiten Verbindungspartners ausbildet auf. Als Teil dieses Oberflächenabschnitts (58) weist das Leistungshalbleiterbauelement (50) eine Metallisierung (52) als zweite Kontaktfläche (56), wobei die Metallisierung (52) aus einem Mehrschichtkontakt zum Halbleitermaterial mit einer Silberschicht als letzter, äußerster Schicht gebildet ist. Auf der dem Substrat (10) abgewandten Seite weist das Leistungshalbleiterbauelement (50) weiter elektrische Kontaktflächen (54) zur schaltungsgerechten Verbindung auf.

Die Ausbildung einer Niedertemperatur-Drucksinterverbindung sieht als nächsten Verfahrensschritt die Beaufschlagung mit Druck und Temperatur vor, wobei hier die Druckbeaufschlagung durch ein nicht dargestelltes Druck- und ein ebenso nicht dargestelltes Gegendruckelement auf die Sinterpaste (40) über das Leistungshalbleiterbauelement (50) bzw. über das Substrat (10) erfolgt. Die Temperaturbeaufschlagung speziell auf die Sinterpaste (40) kann beispielhaft über die Erwärmung der Druck- und Gegendruckelemente erfolgen.

In der erfindungsgemäßen Ausführungsform der Druck- und Temperaturbeaufschlagung erfolgt erst eine Temperaturbeaufschlagung durch thermischen Kontakt der Druck- und Gegendruckelemente, noch ohne die Einleitung der im Rahmen der einer Niedertemperatur-Drucksinterverbindung bekannten Drücke. Hierbei wird einerseits die Reduktion des Metalloxids (20) eingeleitet oder wesentlich beschleunigt und andererseits das Lösungsmittel der Sinterpaste (40) ausgetrieben. Dadurch wird im Rahmen der Temperaturbeaufschlagung das Metalloxid (20) der Kontaktfläche (16) reduziert und eine metallische Oberfläche ausgebildet, die hierdurch der Niedertemperatur-Drucksinterverbindung mit hervorragender Qualität zugänglich ist.

Erst im Anschluss an die Temperaturbeaufschlagung mit den genannten Wirkungen erfolgt die Druckbeaufschlagung zur letztendlichen Ausbildung der Niedertemperatur-Drucksinterverbindung zwischen dem Substrat (10) und dem Leistungshalbleiterbauelement (50). Fig. 1e zeigt eine derartige Anordnung, wobei hier das noch bestehende Metalloxid (240) lateral angrenzend an die Kontaktfläche (16) und das hierauf angeordnete Sintermetall (42) als Verbindungsmittel auf der Oberfläche (18) der Leiterbahnen (14) dargestellt ist.

Mittels des beschriebenen Verfahrens ist es somit möglich eine ersten Verbindungspartner mit einer Oberfläche aus einem unedlen Metall, hier ein Substrat mit Kupferleiterbahnen, mittels einer Niedertemperatur-Drucksinterverbindung mit einem zweiten Verbindungspartner mit einer Edelmetalloberfläche dauerhaft haltbar und elektrisch hervorragend leitend zu verbinden. Selbstverständlich ist dieses Verfahren in analoger Weise auch auf zwei Verbindungspartner mit Oberflächen aus unedlen Metallen gleichermaßen anzuwenden.

Fig. 2 zeigt hierzu eine zweite Anordnung, eines Substrats (10), ähnlich dem unter Fig. 1 beschriebenen einem Kühlbauteil (60) aus Aluminium und einem diese Verbindenden Sintermetall (42). Das Substrat (10) weist gegenüber demjenigen unter Fig. 1a beschriebenen eine weitere Metallschicht (16) auf seiner zweiten Hauptfläche aus, die identisch derjenigen auf der ersten Hauptfläche ausgebildet ist, wobei diese Metallschicht allerdings keine Leiterbahnstruktur aufweist.

Das Kühlbauteil (60) ist ein Kühlkörper, wie er beispielhaft als Strang-Press-Kühlkörper in der Elektrotechnik, speziell auch der Leistungselektronik, vielfältig Anwendung findet. Bei derartigen Kühlkörpern (60) weist die Oberfläche (68) bekanntermaßen eine durch Luftsauerstoff entstandene Schicht aus Aluminiumoxid auf. Diese Schicht ist durch Anwendung des erfindungsgemäßen Verfahrens bei der Herstellung der Niedertemperatur-Drucksinterverbindung mit dem Substrat zu Aluminium reduziert, wodurch im Bereich der Kontaktfläche (66) des Kühlkörpers (60) metallisches Aluminium eine Verbindung mit dem Sintermetall (42) eingehen konnte. Die Verbindung zwischen der Kupferschicht (16) des Substrats (10) und dem Sintermetall (42) ist in grundsätzlich gleicher Weise entstanden wie unter Fig. 1 beschrieben, wobei hier allerdings die Kontaktfläche die gesamte Hauptfläche der Kupferschicht umfasst.

## Patentansprüche

1. Verfahren zur Herstellung einer Anordnung mit einem ersten (10) und einem zweiten Verbindungspartner (50), die mittels einer Niedertemperatur-Drucksinterverbindung miteinander stoffschlüssig verbunden sind, wobei die Verbindungspartner (10, 50) jeweils eine mit dem jeweils anderen Verbindungspartner zu verbindenden Kontaktfläche (16, 56, 66) als Teil eines Oberflächenabschnitts (18, 58, 68) aufweisen, wobei zwischen diesen Kontaktflächen (16, 56, 66) ein edelmetallhaltiges Verbindungsmittel (42) angeordnet ist, und
wobei der Oberflächenabschnitt (18) mindestens eines Verbindungspartners (10) aus einem unedlen Metall besteht und dieses im Bereich angrenzend an die Kontaktfläche (16) ein Metalloxidschicht (240) aufweist, während die Kontaktfläche selbst metallisch,
und somit keine Metalloxidschicht aufweisend, ausgebildet ist und hierdurch in direktem Kontakt mit dem Verbindungsmittel (40) steht, mit folgenden aufeinander folgenden Schritten:
• Bereitstellen eines ersten Verbindungspartners (10) mit einem Oberflächenabschnitt (18) aus einem unedlen Metall mit einer flächigen Metalloxidschicht (20) hierauf;
• Aufbringen eines Reduktionsmittels (30) auf den als erste Kontaktfläche (16) des ersten Verbindungspartners (10) vorgesehenen Bereich des Oberflächenabschnitts (18);
• Aufbringen einer Schicht aus einer Sinterpaste (40) auf das Reduktionsmittel (30);
• Anordnen der zweiten Kontaktfläche (56) des zweiten Verbindungspartners (50) auf der Schicht aus Sinterpaste (40);
• Beaufschlagung der Anordnung mit Temperatur und Druck zur Ausbildung der stoffschlüssigen Niedertemperatur-Drucksinterverbindung, **dadurch gekennzeichnet, dass** die Druckbeaufschlagung nach dem Einsetzen der Temperaturbeaufschlagung einsetzt.

2. Verfahren nach Anspruch 1, wobei
das Reduktionsmittel (30) eine anorganische oder eine organische Säure, vorzugsweise Zitronensäure oder eine gesättigte Fettsäuere, wie Stearinsäure, oder ein ungesättigte Fettsäure ist.

3. Verfahren nach Anspruch 1, wobei
die Sinterpaste (40), bestehend aus Edelmetallflocken und einem Lösungsmittel, mittels Schablonendruck oder mittels eines Sprühverfahrens aufgebracht wird.

4. Verfahren nach Anspruch 1, wobei
das Reduktionsmittel (30) in fester oder flüssiger Phase aufgebracht wird.

5. Verfahren nach Anspruch 1, wobei
das Reduktionsmittel (30) einen Siede- oder Sublimationspunkt aufweist, der nicht oberhalb und bis zu 20°K unterhalb derjenigen Temperatur liegt mit der die Anordnung zur Ausbildung der Niedertemperatur-Drucksinterverbindung beaufschlagt wird.

## Claims

1. A method for the manufacture of an arrangement with a first (10) and a second connection partner (50), which by means of a low temperature pressure sintered joint are joined together in a material bond, wherein
the connection partners (10, 50) in each case have a contact area (16, 56, 66) as part of a surface section (18, 58, 68), to be connected with the other connection partner in each case, wherein
between these contact areas (16, 56, 66) a connecting agent (42) containing a noble metal is arranged, and wherein
the surface section (18) consists of at least one connection partner (10) of a base metal, and the latter, in the region adjacent to the contact area (16), has a metal oxide layer (240), while the contact area itself is of metallic form and thus has no metal oxide layer, and by this means makes direct contact with the connecting agent (40), with the following consecutive steps:
• Preparation of a first connection partner (10) with a surface section (18) of a base metal, with a plane metal oxide layer (20) on the latter;
• Application of a reducing agent (30) onto the region of the surface section (18) provided as a first contact area (16) of the first connection partner (10);
• Application of a layer of a sintering paste (40) onto the reducing agent (30);
• Arrangement of the second contact area (56) of the second connection partner (50) on the layer of sintering paste (40);
• Application of temperature and pressure to the arrangement so as to form the low temperature pressure sintered joint in the form of a material bond, **characterised in that** the application of pressure is deployed after deployment of the application of temperature.

2. The method in accordance with Claim 1, wherein the reducing agent (30) is an inorganic or an organic acid, preferably a citric acid, or a saturated fatty acid, such as stearic acid, or an unsaturated fatty acid.

3. The method in accordance with Claim 1, wherein the sintering paste (40), consisting of noble metal flakes and a solvent, is applied by means of stencil printing or by means of a spraying method.

4. The method in accordance with Claim 1, wherein the reducing agent (30) is applied in a solid or liquid phase.

5. The method in accordance with Claim 1, wherein the reducing agent (30) has a boiling point or sublimation point that lies not above and up to 20 K below the temperature that is applied to the arrangement so as to form the low temperature pressure sintered joint.

## Revendications

1. Procédé de fabrication d'un ensemble comprenant un premier partenaire de liaison (10) et un second partenaire de liaison (50), qui sont reliés ensemble par liaison de matière au moyen d'une liaison par frittage sous pression à basse température, les partenaires de liaison (10, 50) présentant chacun respectivement une surface de contact (16, 56, 66), à lier à chaque autre partenaire de liaison, comme élément d'une section de surface (18, 58, 68), un agent de liaison (42) contenant un métal précieux étant disposé entre ces surfaces de contact (16, 56, 66), et
dans lequel la section de surface (18) d'au moins un partenaire de liaison (10) est constituée d'un métal non précieux et celle-ci comprend dans la zone adjacente à la surface de contact (16) une couche d'oxyde métallique (240), tandis que la surface de contact elle-même est métallique, et donc ne comprend aucune couche d'oxyde métallique, et est ainsi en contact direct avec l'agent de liaison (40), ledit procédé comprenant les étapes suivantes consistant à :
- fournir un premier partenaire de liaison (10) pourvu d'une section de surface (18) en métal non précieux sur laquelle est ménagée une couche d'oxyde métallique plate (20) ;
- appliquer un agent réducteur (30) sur la zone de la section de surface (18) prévue en tant que première surface de contact (16) du premier partenaire de liaison (10) ;
- appliquer une couche faite d'une pâte de frittage (40) sur l'agent réducteur (30) ;
- disposer la seconde surface de contact (56) du second partenaire de liaison (50) sur la couche faite de pâte de frittage (40) ;
- exposer l'ensemble à l'action d'une température et d'une pression pour former la liaison par frittage sous pression à basse température par liaison de matière, **caractérisé en ce que** l'exposition à la pression est mise en oeuvre une fois l'exposition à la température mise en oeuvre.

2. Procédé selon la revendication 1, dans lequel :
l'agent réducteur (30) est un acide inorganique ou organique, de préférence de l'acide citrique ou un acide gras saturé, comme l'acide stéarique, ou un acide gras insaturé.

3. Procédé selon la revendication 1, dans lequel :
la pâte de frittage (40), constituée de flocs de métal précieux et d'un solvant, est appliquée au moyen d'une impression au pochoir ou au moyen d'un procédé de pulvérisation.

4. Procédé selon la revendication 1, dans lequel :
l'agent réducteur (30) est appliqué en phase solide ou liquide.

5. Procédé selon la revendication 1, dans lequel :
l'agent réducteur (30) présente un point d'ébullition ou de sublimation qui n'est pas supérieur à et est jusqu'à 20°K inférieur à la température à laquelle l'ensemble destiné à former la liaison par frittage sous pression à basse température est exposée.
